# EUROPÄISCHE PATENTSCHRIFT

(11) **EP 3 832 319 B1**
(45) Veröffentlichungstag und Bekanntmachung des Hinweises auf die Patenterteilung: **03.01.2024**
(21) Anmeldenummer: 20203772.7
(22) Anmeldetag: 26.10.2020
(51) Int. Cl.: G01R 1/20, G01R 31/36, G01R 35/00, G01R 31/28

(54) **VERFAHREN UND VORRICHTUNG ZUM ÜBERPRÜFEN EINER FUNKTIONSFÄHIGKEIT EINES ALS SYSTEMWIDERSTAND DIENENDEN WIDERSTANDS EINES BATTERIESYSTEMS**
METHOD AND DEVICE FOR CHECKING THE OPERABILITY OF A RESISTOR OF A BATTERY SYSTEM ACTING AS A SYSTEM RESISTOR
PROCÉDÉ ET DISPOSITIF DE VÉRIFICATION DE LA CAPACITÉ FONCTIONNELLE D'UNE RÉSISTANCE D'UN SYSTÈME DE BATTERIE, SERVANT DE RÉSISTANCE DE SYSTÈME

(30) Priorität: 04.12.2019 DE 102019218823
(43) Veröffentlichungstag der Anmeldung: 09.06.2021
(73) Patentinhaber: Robert Bosch GmbH, 70442 Stuttgart (DE)
(72) Erfinder: Landa, Sven, 71732 Tamm (DE)

(56) Entgegenhaltungen:
- DE-A1- 19 532 628
- DE-A1-102017 211 476
- JP-A- H10 319 052
- US-A1- 2013 154 672

## Beschreibung

Die Erfindung betrifft eine Vorrichtung zum Überprüfen einer Funktionsfähigkeit eines als Systemwiderstand dienenden Widerstands eines Batteriesystems. Weitere Aspekte der Erfindung betreffen ein entsprechendes Verfahren zur Überprüfung der Funktionsfähigkeit eines Systemwiderstands eines Batteriesystems sowie ein Fahrzeug, welches ein Batteriesystem und eine solche Vorrichtung umfasst.

### Stand der Technik

Um eine Stromüberwachung mit ASIL-C im Betrieb eines Batteriesystems sicherzustellen, werden üblicherweise zwei Systemwiderstände, die Teile des Batteriesystems sind, verwendet. Nachteilig ist hierbei, dass eine Stromüberwachung erst nach dem Hochlauf bzw. Zuschalten des Batteriesystems durchgeführt werden kann.

Die Druckschrift DE102017211476A1 offenbart ein Verfahren zum Überprüfen einer Funktionsfähigkeit eines als Systemwiderstand dienenden ersten Widerstands eines Batteriesystems vor dem Zuschalten des Batteriesystems. Der Teststrom wird durch eine Konstantstromquelle bereitgestellt,

Automotive safety integrity level (ASIL) "Integritätsgrad der Fahrzeugsicherheit" bezeichnet dabei eine Klassifikation für die Risikoeinstufung. Für ASIL-C wird in der Regel gefordert, dass eine zweikanalige Architektur vorgesehen ist, um die Zuverlässigkeit jederzeit gewährleisten zu können.

Eine Aufgabe der Erfindung kann darin gesehen werden, ein Verfahren und eine Vorrichtung für eine Stromüberwachung gemäß ASIL-C sowohl vor dem Zuschalten eines Batteriesystems als auch während des Betriebs des Batteriesystems bereitzustellen.

### Offenbarung der Erfindung

Es wird eine Vorrichtung zum Überprüfen einer Funktionsfähigkeit eines als Systemwiderstand dienenden ersten Widerstands eines Batteriesystems vorgeschlagen. Die Vorrichtung umfasst ein Mittel zum Bereitstellen eines modulierten Teststroms, einen Schalter, einen zweiten Widerstand, ein erstes Messmittel und ein zweites Messmittel, wobei das erste Messmittel dazu eingerichtet ist, einen ersten Spannungswert einer über den ersten Widerstand abfallenden Wechselspannung zu erfassen, einen ersten Stromwert zu bestimmen und den ersten Stromwert mit Hilfe einer Verbindung an das zweite Messmittel zu übertragen, und wobei das zweite Messmittel dazu eingerichtet ist einen zweiten Spannungswert einer über den zweiten Widerstand abfallenden Wechselspannung zu erfassen und einen zweiten Stromwert zu bestimmen.

Das Mittel zum Bereitstellen eines modulierten Teststroms, der erste Widerstand und der zweite Widerstand sind in Reihe geschaltet und bilden einen Teststromkreis. Ferner ist vorgesehen, dass das zweite Messmittel dazu eingerichtet ist, den ersten Stromwert und den zweiten Stromwert zu vergleichen und ein erstes Signal zu erzeugen, wenn der erste Stromwert und der zweite Stromwert im Wesentlichen gleich sind, wobei das erste Signal die Funktionsfähigkeit des ersten Widerstands repräsentiert.

Als Mittel zum Bereitstellen eines modulierten Teststroms sind grundsätzlich alle Mittel geeignet, welche einen Stromfluss modulieren können. Insbesondere Halbleiterschalter, welche in den Teststromkreis eingesetzt sind und über einen Signalgenerator mit einem modulierten Signal versorgt werden, sind grundsätzlich geeignet. Alternativ dazu kann das Mittel beispielsweise als ein Mischer und ein Signalgenerator ausgestaltet sein. Das modulierte Signal wird dem Teststrom bei der Modulation aufgeprägt. Des Weiteren ist insbesondere auch eine Modulation in Form eines Rechtecksignals denkbar, bei der der Teststrom mit der Frequenz des Rechtecksignals jeweils ein- und wieder ausgeschaltet wird.

Der Teststrom kann insbesondere in Form eines Sinussignals oder Rechtecksignals moduliert werden.

Durch das Mittel zum Bereitstellen eines modulierten Teststroms wird im Teststromkreis ein Teststrom bereitgestellt, wobei dazu eine Batterie des Batteriesystems, das Mittel zum Bereitstellen eines modulierten Teststroms, der Schalter, der erste Widerstand und der zweite Widerstand in Reihe verschaltet sind. Durch Öffnen des Schalters wird entsprechend der Teststrom unterbrochen und durch Schließen des Schalters wird ein Fluss des Teststroms in dem Teststromkreis ermöglicht. Je nach Ausgestaltung des Mittels zum Bereitstellen des modulierten Teststroms kann der Schalter auch Teil des Mittels zum Bereitstellen eines modulierten Teststroms sein.

Da in einer Reihenschaltung der gleiche Strom fließen muss, fließt insbesondere durch den zu testenden ersten Widerstand, welcher als Systemwiderstand des Batteriesystems dient, und durch den zweiten Widerstand der gleiche modulierte Teststrom. Wird nun jeweils die über die jeweiligen Widerstände abfallende Wechselspannung bestimmt, können unter Kenntnis der Widerstandswerte des ersten und des zweiten Widerstands zwei unabhängige Messungen des im Teststromkreis fließenden modulierten Teststroms vorgenommen werden. Insbesondere werden bei der Messung zwei voneinander unabhängige Messmittel verwendet, so dass die Messungen jeweils voneinander unabhängig sind. Stimmen diese beiden voneinander unabhängig gemessenen ersten und zweiten Stromwerte im Wesentlichen überein, so liegt kein Fehler vor und durch Generieren des ersten Signals kann die Funktionsfähigkeit des ersten Widerstands angezeigt werden.

Durch das Verwenden eines modulierten Teststroms im Teststromkreis ist das Verfahren unabhängig von eventuellen weiteren Gleichströmen, welche über den als Systemwiderstand dienenden ersten Widerstand fließen können, sofern das Batteriesystem zum Zeitpunkt der Messung in einem aktiven Zustand ist und beispielsweise mit einem Bordnetz eines Fahrzeugs verbunden ist. Auch ist es möglich, den modulierten Teststrom von anderen Wechselströmen unterscheidbar zu machen, welche Beispielsweise zur Versorgung eines Bordnetzes ebenfalls über den ersten Widerstand fließen. Dazu wird die Modulation derart gewählt, dass der Teststrom sich insbesondere in der Form der Modulation und/oder der Frequenz von anderen Wechselströmen unterscheidet.

Entsprechend ist bevorzugt vorgesehen, dass das Mittel zum Bereitstellen eines modulierten Teststroms den Teststrom mit einer Messfrequenz zu modulieren und dass das erste Messmittel und das zweite Messmittel dazu eingerichtet sind, jeweils bei der Erfassung von Spannungswerten eine Frequenzfilterung vorzunehmen, welche Gleichspannung und Wechselspannungen mit von der Messfrequenz abweichenden Frequenzen unterdrückt.

Hierzu kann beispielsweise ein Filter in Hardware implementiert werden, welcher als Frequenzfilter dient und nur Anteile mit der aufmodulierten Frequenz passieren lässt und insbesondere die Gleichspannungsanteile herausfiltert. Anschließend wird durch das erste bzw. das zweite Messmittel die Amplitude der Spannung bei der bekannten Messfrequenz gemessen.

Alternativ dazu ist es denkbar, die an dem jeweiligen Widerstand abfallende Spannung mit einer Frequenz abzutasten, welche wesentlich höher ist, als die Messfrequenz und anschließend Wellenform des erfassten Signals zu analysieren, um den Signalanteil bzw. die Amplitude der Spannung bei der Messfrequenz zu ermitteln.

Des Weiteren ist es denkbar, für die Filterung die an dem jeweiligen Widerstand abfallende Spannung mit einer Frequenz abzutasten, welche mindestens doppelt so groß ist wie die Messfrequenz und anschließend den Signalanteil bzw. die Amplitude der Spannung bei der Messfrequenz über eine Fourieranalyse, beispielsweise in Form einer FFT, zu ermitteln.

Bei dem Vergleich der Stromwerte wird unter "im Wesentlichen gleich" verstanden, dass die Stromwerte im Rahmen üblicher Messtoleranzen übereinstimmen. Beispielsweise kann ein Fehler von weniger als +/-5 %, bevorzugt von weniger als 2% und besonders bevorzugt von weniger als 1% zugelassen werden.

Bevorzugt ist im Teststromkreis zusätzlich ein dritter Widerstand vorgesehen, wobei das erste Messmittel dazu eingerichtet ist, zusätzlich einen dritten Spannungswert einer über den dritten Widerstand abfallenden Wechselspannung zu erfassen, einen dritten Stromwert zu bestimmen und den dritten Stromwert mit Hilfe der Verbindung an das zweite Messmittel zu übertragen. Zudem ist das zweite Messmittel eingerichtet, das erste Signal zu erzeugen, wenn der erste Stromwert, der zweite Stromwert und der dritte Stromwert im Wesentlichen gleich sind.

Bevorzugt sind die Widerstandswerte des ersten Widerstands, des zweiten Widerstands und falls vorhanden des dritten Widerstands jeweils unterschiedlich gewählt. Dabei weist der erste Widerstand, welcher auch als Systemwiderstand dient, bevorzugt den geringsten Widerstandswert auf, damit die Verlustleistung im Betrieb des Batteriesystems über den ersten Widerstand gering ist. Des Weiteren ist es bevorzugt, dass die Widerstandswerte zwischen dem ersten und dem dritten Widerstand sich um mehr als einen Faktor 100 unterscheiden.

Die Nominalwerte der Widerstände sind dabei bekannt. Bevorzugt ist der Nominalwert des ersten Widerstand sowie gegebenenfalls des dritten Widerstands dem ersten Messmittel bekannt und der Nominalwert des zweiten Widerstands ist dem zweiten Messmittel bekannt. Dazu können die Nominalwerte jeweils in einem Speicher des jeweiligen Messmittels abgelegt sein.

Bevorzugt ist das erste Messmittel ein Analog-Front-End und das zweite Messmittel eine Steuereinheit eines Batteriemanagementsystems des Batteriesystems.

Bei dem Analog-Front-End kann es sich insbesondere um eine Einheit zum Erfassen von Messdaten des Batteriesystems handeln, welche insbesondere analoge Messwerte erfasst, digitalisiert und dem Batteriemanagementsystem, insbesondere der Steuereinheit des Batteriemanagementsystems, zur Verfügung stellt. Um eine unabhängige zweite Strommessung zu ermöglichen ist es bevorzugt, dass die Steuereinheit ebenfalls über zumindest einen Analog/DigitalWandler verfügt, um zumindest den zweiten Spannungswert unabhängig von dem Analog-Front-End zu erfassen.

Bevorzugt weist das erste Messmittel einen Verstärker mit einem dynamischen Verstärkungsfaktor auf. Der Verstärker bereitet dabei eine Eingangsspannung auf, bevor diese beispielsweise unter Verwendung eines Analog/Digital-Wandlers gemessen wird.

Bevorzugt ist das erste Messmittel dazu eingerichtet, unter Verwendung eines ersten Verstärkungsfaktors den ersten Stromwert zu bestimmen und unter Verwendung eines zweiten Verstärkungsfaktors den dritten Stromwert zu bestimmen und ein zweites Signal zu erzeugen, wenn der erste Stromwert und der dritte Stromwert im Wesentlichen gleich sind, wobei das zweite Signal die Funktionsfähigkeit des Verstärkers repräsentiert.

Das erste Messmittel umfasst beispielsweise neben dem Verstärker mit einem dynamischen Verstärkungsbereich einen Multiplexer, mit dem der Verstärker wahlweise mit dem ersten Widerstand oder dem dritten Widerstand verbunden werden kann. Um die Funktionsfähigkeit des Verstärkers mit dem dynamischen Verstärkungsfaktor zu testen, wird bevorzugt ein Verhältnis der Widerstandswerte des ersten Widerstands und des zweiten Widerstands so gewählt, dass sich diese deutlich unterscheiden und zur Bestimmung des ersten und des dritten Spannungswertes jeweils verschiedene dynamische Verstärkungsfaktoren eingestellt werden. Weichen die unter Verwendung des eingestellten Verstärkungsfaktors und des Nominalwerts des jeweiligen Widerstands bestimmte erste und dritte Stromwerte voneinander ab, so kann auf einen Fehler im Verstärker geschlossen werden.

Wird kein erstes Signal erzeugt, d.h. der erste Stromwert, der zweite Stromwert und/oder der dritte Stromwert weisen eine Differenz oberhalb einer Toleranz zueinander auf, so wird das Verfahren bevorzugt mindestens einmal erneut durchgeführt. Wird das Verfahren mehrmals durchlaufen, ohne dass das erste Signal erzeugt wird, so ist es bevorzugt, ein Fehlersignal zu erzeugen. Wird das Verfahren vor dem Anlauf des Batteriesystems durchgeführt, so ist es bevorzugt, dass das Fehlersignal den Anlauf des Batteriesystems verhindert. Wird das Verfahren im laufenden Betrieb durchgeführt, so ist bevorzugt vorgesehen, dass das Fehlersignal mit dem Batteriesystem verbundene Komponenten, beispielsweise das Bordnetz eines Fahrzeugs, in einen sicheren Zustand versetzt und anschließend eine Abschaltung des Batteriesystems veranlasst. Bei einem Fahrzeug kann das Versetzen in einen sicheren Zustand insbesondere umfassen, dass das Fahrzeug zum Stillstand gebracht wird.

Bevorzugt werden der erste Stromwert, der zweite Stromwert und, sofern vorhanden, der dritte Stromwert jeweils mit in einem Speicher hinterlegten ersten Referenzstromwert, einem zweiten Referenzstromwert und einem dritten Referenzstromwert verglichen, sodass ein Alterungsdrift frühzeitig erkennbar ist. Bei einer Abweichung oberhalb einer Toleranz kann dann ein Fehlersignal generiert werden.

Bevorzugt wird zusätzlich eine Umgebungstemperatur erfasst und es wird überprüft, ob die Umgebungstemperatur unterhalb eines für den Betrieb des Batteriesystems zulässigen Schwellenwerts liegt. Ist dies der Fall, wird das erste Signal in Abhängigkeit des ersten Stromwerts, des zweiten Stromwerts, des dritten Stromwerts - sofern vorhanden - und der Umgebungstemperatur erzeugt.

Der durch das Mittel zum Bereitstellen eines modulierten Teststroms bereitgestellt modulierte Teststrom ist bevorzugt ein Wechselstrom mit genau definierten Eigenschaften und ist bis auf übliche Toleranzen konstant, so dass Fehler der Vorrichtung bzw. des Verfahrens bei sequentiellem Erfassen des ersten, zweiten und ggf. dritten Stromwerts minimal sind.

Ein weiterer Aspekt der Erfindung ist es, ein Verfahren zum Überprüfen einer Funktionsfähigkeit eines ersten Widerstands eines Batteriesystems, welcher als Systemwiderstand dient, bereitzustellen.

Das Verfahren wird bevorzugt unter Verwendung einer der hierin beschriebenen Vorrichtungen ausgeführt. Entsprechend gelten im Rahmen einer der Vorrichtungen beschriebene Merkmale für das Verfahren und umgekehrt gelten im Rahmen des Verfahrens beschriebene Merkmale für die Vorrichtungen.

Das Verfahren umfasst zumindest das Schließen eines Schalters, um in einem Teststromkreis mit einem Mittel zum Bereitstellen eines modulierten Teststroms, einem ersten Widerstand und einem zweiten Widerstand, welche in Reihe geschaltet sind, einen Teststrom bereitzustellen, das Erfassen eines ersten Spannungswerts einer über den ersten Widerstand abfallenden Wechselspannung mit Hilfe eines ersten Messmittels, das Bestimmen eines ersten Stromwerts in Abhängigkeit des ersten Spannungswerts und eines Nennwerts des ersten Widerstands, das Erfassen eines zweiten Spannungswerts einer über den zweiten Widerstand abfallenden Wechselspannung mit Hilfe des zweiten Messmittels, das Bestimmen eines zweiten Stromwerts in Abhängigkeit des zweiten Spannungswerts und eines Nennwerts des zweiten Widerstands, das Übertragen des ersten Stromwerts an das zweite Messmittel sowie das Erzeugen eines ersten Signals, das die Funktionsfähigkeit des ersten Widerstands repräsentiert, wenn der erste Stromwert und der zweite Stromwert im Wesentlichen gleich sind.

Bevorzugt wird nach Beenden der Überprüfung der Schalter wieder geöffnet.

Das vorgeschlagene Verfahren kann jederzeit ausgeführt werden und ist unabhängig davon, ob weitere Ströme über den als Systemwiderstand dienenden ersten Widerstand fließen, beispielsweise zur Versorgung eines Bordnetzes eines Fahrzeugs.

Beispielsweise wird das Verfahren vor dem Zuschalten des Batteriesystems ausgeführt, also bevor das Batteriesystem mit elektrischen Verbrauchern oder einem Bordnetz eines Fahrzeugs verbunden wird.

Zusätzlich oder alternativ sind beispielsweise regelmäßige Überprüfungen des Batteriesystems denkbar, welche nach Zuschalten des Batteriesystems ausgeführt werden.

Das Verfahren kann zudem zu Beginn das Versetzen eines Batteriemanagementsystems in einen Diagnosemodus umfassen, wobei entsprechend der Diagnosemodus nach Beenden der Überprüfung wieder verlassen wird. Das Batteriemanagementsystem kann dabei insbesondere das erste Messmittel und das zweite Messmittel umfassen.

Bevorzugt umfasst der Teststromkreis in der Reihenschaltung zusätzlich einen dritten Widerstand und das Verfahren umfasst ferner das Erfassen eines dritten Spannungswerts einer über einen dritten Widerstand abfallenden Wechselspannung mit Hilfe des ersten Messmittels, und das Bestimmen eines dritten Stromwerts in Abhängigkeit des dritten Spannungswerts und eines Nennwerts des dritten Widerstands, das Übertragen des dritten Stromwerts an das zweite Messmittel. Ferner ist hierbei vorgesehen, dass das erste Signal erzeugt wird, wenn der erste Stromwert, der zweite Stromwert und der dritte Stromwert im Wesentlichen gleich sind.

Bevorzugt weist das erste Messmittel einen Verstärker mit einem dynamischen Verstärkungsfaktor auf, wobei der erste Stromwert unter Verwendung eines ersten Verstärkungsfaktors bestimmt wird und der dritte Stromwert unter Verwendung eines zweiten Verstärkungsfaktors bestimmt wird und das Verfahren ferner das Erzeugen eines zweites Signals umfasst, wenn der erste Stromwert und der dritte Stromwert im Wesentlichen gleich sind, wobei das zweite Signal die Funktionsfähigkeit des Verstärkers repräsentiert.

Ein weiterer Aspekt der Erfindung betrifft ein Fahrzeug welches ein Batteriesystem mit einem ersten Widerstand als Systemwiderstand sowie eine der hierin beschriebenen Vorrichtungen zur Überprüfung einer Funktionsfähigkeit des ersten Widerstands umfasst.

### Vorteile der Erfindung

Mit der Erfindungsgemäßen Vorrichtung bzw. dem erfindungsgemäßen Verfahren ist es möglich, den ersten Widerstand, also den Systemwiderstand des Batteriesystems, jederzeit gemäß ASIL- C zu überprüfen. Dabei ist es nicht erforderlich, zwei Systemwiderstände vorzusehen, da die Messung der Funktionsfähigkeit des Systemwiderstands über zwei unabhängige Messmittel erfolgt und damit abgesichert ist. Die Überprüfung kann dabei insbesondere sowohl vor einem Zuschalten des Batteriesystems als auch während des Betriebs des Batteriesystems erfolgen.

In einer vorteilhaften Ausführungsform der Vorrichtung bzw. des Verfahrens ist zudem eine Überprüfung der Funktionsfähigkeit des ersten Messmittels möglich, indem mit dem ersten Messmittel der über zwei Widerstände fließende modulierte Teststrom mit bekannten, gleichbleibenden Eigenschaften unter Verwendung von verschiedenen Verstärkungsfaktoren ermittelt wird.

### Kurze Beschreibung der Zeichnungen

Ausführungsformen der Erfindung werden anhand der Zeichnungen und der nachfolgenden Beschreibung näher erläutert.

Es zeigen:
Figur 1 ein Ersatzschaltbild eines Batteriesystems mit einer Vorrichtung zum Überprüfen einer Funktionsfähigkeit eines ersten Widerstands des Batteriesystems,
Figur 2 ein weiteres Ersatzschaltbild eines Batteriesystems mit der Vorrichtung zum Überprüfen der Funktionsfähigkeit des ersten Widerstands des Batteriesystems,
Figur 3 ein Verfahren zum Überprüfen der Funktionsfähigkeit des ersten Widerstands des Batteriesystems und
Figur 4 ein weiteres Verfahren zum Überprüfen der Funktionsfähigkeit des ersten Widerstands des Batteriesystems.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

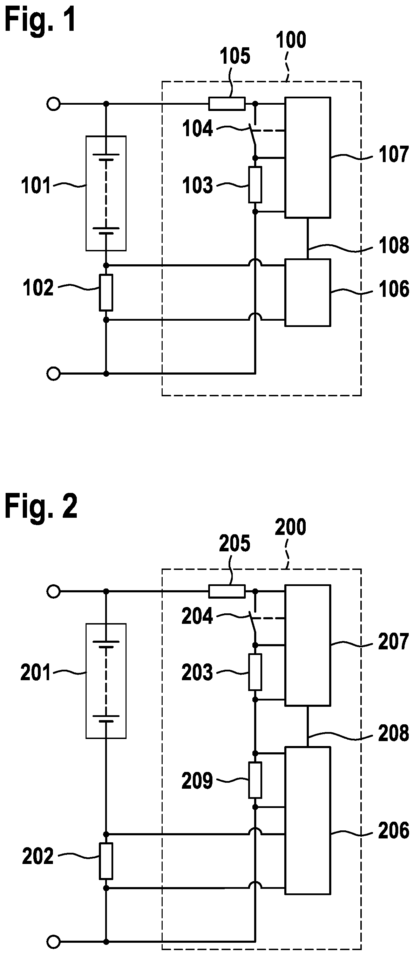

Figur 1 zeigt ein Ersatzschaltbild eines Batteriesystems mit einer Vorrichtung 100 zum Überprüfen einer Funktionsfähigkeit eines ersten Widerstands 102 des Batteriesystems. Der erste Widerstand 102 dient dabei als Systemwiderstand des Batteriesystems, über den beispielsweise der Stromfluss ermittelt wird. Das Batteriesystem umfasst zumindest eine Batterie 101, insbesondere eine Lithium-Ionen-Batterie, welche aus mehreren Batteriezellen und/oder Batteriemodulen bestehen kann.

Die Vorrichtung 100 weist ein Mittel 105 zur Bereitstellung eines modulierten Teststroms, einen Schalter 104, einen zweiten Widerstand 103, ein erstes Messmittel 106 und ein zweites Messmittel 107 auf. Dabei wird ein Teststromkreis gebildet, welcher die Batterie 101, das Mittel 105, den Schalter 104, den zweiten Widerstand 103 und den ersten Widerstand 102 umfasst.

Das Mittel 105 ist beispielsweise als ein Halbleiterschalter und Signalgenerator ausgestaltet. Alternativ dazu kann es beispielsweise als ein Mischer und ein Signalgenerator ausgestaltet sein.

Das erste Messmittel 106 weist eine erste Spannungsversorgung (nicht dargestellt) und das zweite Messmittel 107 weist eine zweite Spannungsversorgung (nicht dargestellt) auf. Somit weisen das erste Messmittel 106 und das zweite Messmittel 107 jeweils voneinander unabhängige Spannungsversorgungen bzw. Referenzspannungen auf. Das bedeutet, dass Spannungsfehler der ersten Spannungsversorgung des ersten Messmittels 106 nicht auf das zweite Messmittel 107 übertragen werden. Das erste Messmittel 106 und das zweite Messmittel 107 sind mit einer Verbindung 108 bzw. über eine Verbindung 108 verbunden. Bei der Verbindung 108 handelt es sich um eine Datenleitung. Somit weisen das erste Messmittel 106 und das zweite Messmittel 107 lediglich eine spannungsunabhängige Verbindung auf, nämlich eine Datenleitung.

Das erste Messmittel 106 ist dazu eingerichtet, einen ersten Spannungswert zu erfassen. Beim ersten Spannungswert handelt es sich um eine Wechselspannung, welche über bzw. am ersten Widerstand 102 abfällt. Der erste Widerstand 102 wird auch als Systemwiderstand des Batteriesystems bezeichnet und ist somit Teil des Batteriesystems. Das zweite Messmittel 107 ist dazu eingerichtet, einen zweiten Spannungswert zu erfassen. Beim zweiten Spannungswert handelt es sich um eine Wechselspannung welche über bzw. am zweiten Widerstand 103 abfällt. Die Messmittel 106, 107 sind dabei derart eingerichtet, dass Gleichspannungsanteile herausgefiltert werden. Des Weiteren ist es bevorzugt, dass der Teststrom mit einer Messfrequenz moduliert ist und die Messmittel 106, 107 Filter umfassen, welche nur Signalanteile bei dieser Messfrequenz passieren lassen. Somit wird nur der auf den modulierten Teststrom entfallende Spannungsabfall an den jeweiligen Widerständen durch die Messmittel 106, 107 als Spannungswerte erfasst.

Das zweite Mittel 107 ist bevorzugt ferner dazu eingerichtet, den Schalter 104 zu schalten, also je nach Bedarf zu öffnen und zu schließen und entsprechend das Fließen eines Teststroms in dem Teststromkreis zu ermöglichen oder zu unterbrechen.

Das zweite Messmittel 107 ist beispielsweise eine Steuereinheit eines Batteriemanagementsystems des Batteriesystems, insbesondere ein Zentralrechner. Das erste Mittel 106 ist beispielsweise ein analoges Frontend des Batteriesystems.

Bevorzugt ist der Widerstandswert des zweiten Widerstands 103 wesentlich größer als der Widerstandswert des ersten Widerstands 102, beispielsweise um den Faktor Hundert. Die Vorrichtung 100 ist beispielsweise auf einer Leiterplatte oder Platine angeordnet, wohingegen der erste Widerstand 102 als Teil des Batteriesystems auf einem von der Leiterplatte bzw. Platine unabhängigen Träger angeordnet ist.

Figur 2 zeigt ein weiteres Ersatzschaltbild des Batteriesystems mit einer Vorrichtung 200 zum Überprüfen der Funktionsfähigkeit des ersten Widerstands 202 des Batteriesystems.

Wie bereits mit Bezug zur Figur 1 beschrieben umfasst das Batteriesystem neben dem ersten Widerstand 202 zumindest die Batterie 201, insbesondere eine Lithium-Ionen-Batterie, welche aus mehreren Batteriezellen und/oder Batteriemodulen bestehen kann.

Die Vorrichtung 200 weist wieder ein Mittel 205 zum Bereitstellen eines modulierten Teststroms, einen Schalter 204, einen zweiten Widerstand 203, ein erstes Messmittel 206 und ein zweites Messmittel 207 auf. Zusätzlich umfasst die Vorrichtung 200 der in Figur 2 dargestellten zweiten Ausführungsform einen dritten Widerstand 209. Dabei wird wiederum ein Teststromkreis gebildet, welcher die Batterie 201, das Mittel 205, den Schalter 204, den zweiten Widerstand 203, den dritten Widerstand 209 und den ersten Widerstand 202 umfasst.

Das Mittel 205 ist beispielsweise wieder als ein Halbleiterschalter mit Signalgenerator oder als ein Mischer und Signalgenerator ausgestaltet.

Wiederum weist das erste Messmittel 206 eine erste Spannungsversorgung (nicht dargestellt) auf und das zweite Messmittel 207 eine zweite Spannungsversorgung (nicht dargestellt) auf. Das erste Messmittel 206 und das zweite Messmittel 207 sind wie mit Bezug zur ersten Ausführungsform der Figur 1 beschrieben mit einer Verbindung 208 verbunden, wobei die Verbindung 208 insbesondere eine Datenleitung ist.

Die Widerstandswerte des ersten Widerstands 202, des zweiten Widerstands 203 und des dritten Widerstands 209 sind unterschiedlich gewählt. Die Widerstandswerte des ersten Widerstands 202 und des dritten Widerstands 209 liegen bevorzugt um einen Faktor von mehreren Hundert auseinander. Die Nominalwerte bzw. Nennwerte des ersten Widerstands 202 und des dritten Widerstands 209 sind beispielsweise in einem Speicher des ersten Messmittels 206 hinterlegt, d. h. sie sind dem ersten Messmittel 206 bekannt. Der Nominalwert bzw. Nennwert des zweiten Widerstands 203 ist beispielsweise in einem Speicher des zweiten Messmittels 207 hinterlegt, d. h. er ist dem zweiten Messmittel 207 bekannt. Das erste Messmittel 206 umfasst beispielsweise einen Multiplexer und eine Verstärkerschaltung mit einem dynamischen Verstärkungsbereich. Das zweite Messmittel 207 ist beispielsweise ein Mikrocontroller. Der erste Widerstand 202 des Batteriesystems weist dabei den geringsten Widerstandswert auf, damit die Verlustleistung im Betrieb des Batteriesystems über den ersten Widerstand 202 gering ist. Der erste Widerstand 202 weist beispielsweise einen Widerstandswert von 100 µΩ, der zweite Widerstand 203 einen Widerstandswert von 50 mΩ und der dritte Widerstand 209 einen Widerstandswert von 2,2 Ω auf.

In einem Ausführungsbeispiel ist das erste Messmittel 206 dazu eingerichtet, die Verstärkung der Verstärkerschaltung zu überprüfen, da im späteren Betrieb des Batteriesystems sichergestellt sein muss, dass der Verstärker des ersten Messmittels 206 einwandfrei funktioniert, um eine Stromüberwachung nach ASIL-C mit nur einem Systemwiderstand gewährleisten zu können.

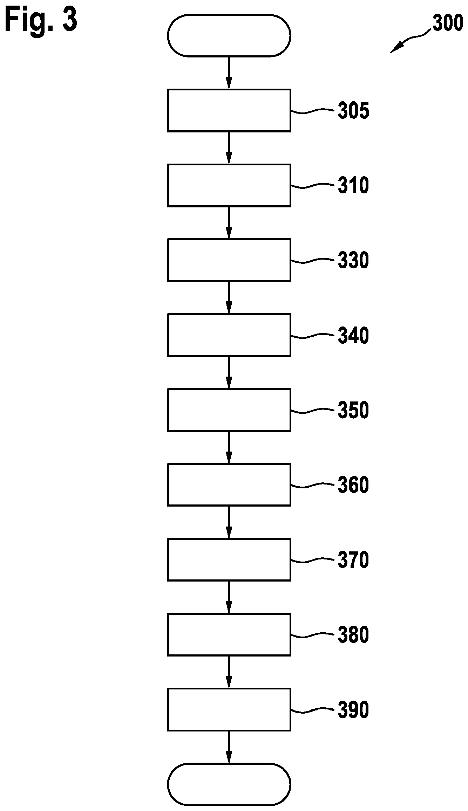

Figur 3 zeigt ein Verfahren 300 zum Überprüfen einer Funktionsfähigkeit eines ersten Widerstands 102 eines Batteriesystems. Das Verfahren wird mit einem Schritt 305 gestartet, in dem ein Batteriemanagementsystem, welches ein erstes Messmittel 106 und ein zweites Messmittel 107 umfasst, vergleiche Figur 1, in einen Diagnosemodus geschaltet wird. In einem folgenden Schritt 310 wird der Schalter 104 geschlossen, sodass ein geschlossener Teststromkreis erzeugt wird, der das Strombegrenzungsmittel 105, den Schalter 104, den ersten Widerstand 102, den zweiten Widerstand 103 und die Batterie 101 umfasst.

In einem folgenden Schritt 330 wird ein erster Spannungswert einer über den ersten Widerstand 102 abfallenden Wechselspannung mit Hilfe des ersten Messmittels 106 erfasst. In einem folgenden Schritt 340 wird ein erster Stromwert in Abhängigkeit des ersten Spannungswerts und eines Nennwerts des ersten Widerstands 102 bestimmt. In einem folgenden Schritt 350 wird der erste Stromwert an das zweite Messmittel 107 übertragen. In einem folgenden Schritt 360 wird ein zweiter Spannungswert einer über den zweiten Widerstand 103 abfallenden Wechselspannung erfasst. In einem folgenden Schritt 370 wird ein zweiter Stromwert in Abhängigkeit des zweiten Spannungswerts und eines Nennwerts des zweiten Widerstands 103 bestimmt. Die Schritte 330 bis 370 können auch in einer anderen Reihenfolge durchgeführt werden.

In einem folgenden Schritt 380 wird ein erstes Signal erzeugt, das die Funktionsfähigkeit des ersten Widerstands 102 repräsentiert, wenn der erste Stromwert und der zweite Stromwert im Wesentlichen einen gleichen Wert aufweisen. Durch die Verwendung der Nennwerte der Widerstände können Veränderungen, z. B. Fehlfunktion oder Altersdrift innerhalb des ersten Widerstands 102 durch eine Stromveränderung erkannt werden. Dabei ist der zweite Stromwert sozusagen der Richtwert mit dem der erste Stromwert verglichen wird. Dabei kann der erste Stromwert innerhalb eines Toleranzbereichs um den zweiten Stromwert abweichen. Mit anderen Worten der Begriff "im Wesentlichen gleich" bedeutet, dass sich der erste Stromwert im Toleranzbereich bzw. Toleranzband des ersten Stromwerts befindet. Optional können der erste Stromwert und der zweite Stromwert in einem Speicher des zweiten Messmittels 107 gespeichert werden.

In einem folgenden Schritt 390 wird der Diagnosemodus erfolgreich beendet, wobei der Schalter 104 wieder geöffnet wird. Das Verfahren kann jederzeit, also beispielsweise während des Betriebs oder vor dem Zuschalten des Batteriesystems ausgeführt werden. Wird das Verfahren vor dem Zuschalten ausgeführt wird bevorzugt zudem durch das erste Messmittel 106 das Batteriesystem in einen Betriebsmodus geschaltet. Dabei wird ein Vorladesignal erzeugt, das einen Vorladevorgang eines Zwischenkreises des Batteriesystems startet.

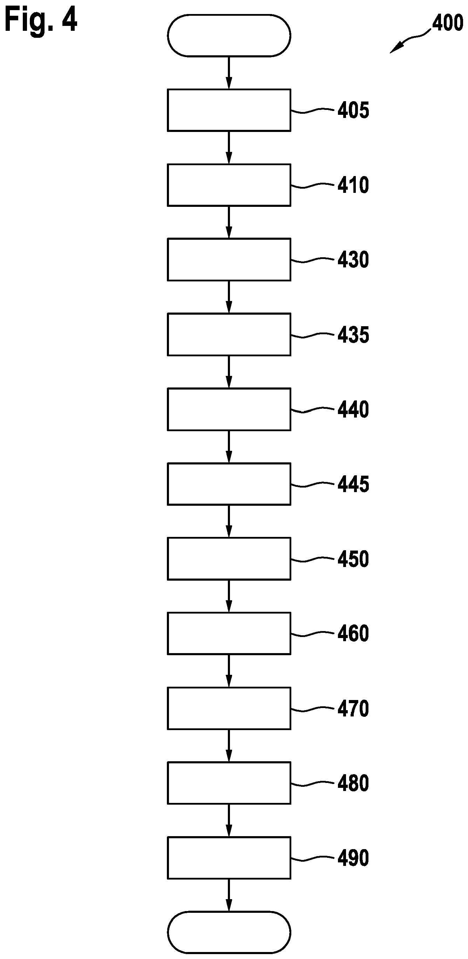

Figur 4 zeigt ein Verfahren 400 zum Überprüfen einer Funktionsfähigkeit eines ersten Widerstands 202 eines Batteriesystems. Das Verfahren wird mit einem Schritt 405 gestartet, in dem ein Batteriemanagementsystem, welches das erste Messmittel 206 und das zweite Messmittel 207 umfasst, in einen Diagnosemodus geschaltet wird. In einem folgenden Schritt 410 wird der Schalter 204 geschlossen, sodass ein geschlossener Teststromkreis entsteht. In einem folgenden Schritt 430 wird ein erster Spannungswert einer über den ersten Widerstand 202 abfallenden Wechselspannung mit Hilfe des ersten Messmittels 206 erfasst. In einem folgenden Schritt 435 wird ein dritter Spannungswert einer über den dritten Widerstand 209 abfallenden Wechselspannung mit Hilfe des ersten Messmittels 206 erfasst. In einem folgenden Schritt 440 wird ein erster Stromwert in Abhängigkeit des ersten Spannungswerts und eines Nennwerts des ersten Widerstands 202 bestimmt. In einem folgenden Schritt 445 wird ein dritter Stromwert in Abhängigkeit des dritten Spannungswerts und eines Nennwerts des dritten Widerstands 209 bestimmt. Mit anderen Worten der erste Spannungswert und der dritte Spannungswert werden zeitlich nacheinander erfasst, beispielsweise mit Hilfe eines Multiplexers. Nochmals anders ausgedrückt wird zur Erfassung der ersten Spannungswerte und der dritten Spannungswerte ein sequentielles Sampling durchgeführt, wobei für den ersten Spannungswert eine andere Verstärkung bzw. ein anderer Verstärkungsfaktor verwendet wird als für den dritten Spannungswert.

In einem folgenden Schritt 450 werden der erste Stromwert und der dritte Stromwert an das zweite Messmittel 207 übertragen. In einem folgenden Schritt 460 wird ein zweiter Spannungswert einer über den zweiten Widerstand 203 abfallenden Wechselspannung erfasst. In einem folgenden Schritt 470 wird ein zweiter Stromwert in Abhängigkeit des zweiten Spannungswerts und eines Nennwerts des zweiten Widerstands 203 bestimmt. Die Schritte 430 bis 470 können auch in einer anderen Reihenfolge durchgeführt werden.

In einem folgenden Schritt 480 wird das erste Signal erzeugt, das die Funktionsfähigkeit des ersten Widerstands 202 repräsentiert, wenn der erste Stromwert, der zweite Stromwert und der dritte Stromwert im Wesentlichen den gleichen Wert aufweisen. Dabei ist auch hier der zweite Stromwert sozusagen der Richtwert mit dem der erste Stromwert und der dritte Stromwert verglichen werden. Dabei können der erste Stromwert und der dritte Stromwert innerhalb eines Toleranzbereichs um den zweiten Stromwert abweichen. Mit anderen Worten der Begriff "im Wesentlichen gleich" bedeutet, dass sich der erste Stromwert und der dritte Stromwert im Toleranzbereich bzw. Toleranzband des ersten Stromwerts befinden.

In einem folgenden Schritt 490 wird der Diagnosemodus erfolgreich beendet und das erste Mittel schaltet das Batteriesystem in einen Betriebsmodus, wobei der Schalter 204 wieder geöffnet wird. Ist das Batteriesystem bisher nicht zugeschaltet, wird bevorzugt zudem ein Vorladesignal erzeugt, das einen Vorladevorgang eines Zwischenkreises des Batteriesystems startet. Im Anschluss daran, kann die Zuschaltung eines Relais erfolgen, sodass das Batteriesystem betriebsbereit ist.

In einem optionalen Schritt 495, der zeitlich nach der Bestimmung des ersten Stromwerts und des dritten Stromwerts, beispielsweise nach dem Schritt 445 durchgeführt wird, überprüft das erste Messmittel 206, das einen Verstärker mit einem dynamischen Verstärkungsfaktor aufweist, die Funktionsfähigkeit des Verstärkers. Dabei wird ausgenutzt, dass der erste Stromwert unter Verwendung eines ersten Verstärkungsfaktors bestimmt wird und der dritte Stromwert unter Verwendung eines zweiten Verstärkungsfaktors bestimmt wird. Wenn der erste Stromwert und der dritte Stromwert im Wesentlichen gleich sind, wird ein zweites Signals erzeugt, wobei das zweite Signal die Funktionsfähigkeit des Verstärkers repräsentiert. Diese Prüfung ist für die Messbereichsbestimmung des ersten Messmittels 206 erforderlich, da das erste Messmittel 206 in der Lage ist, unterschiedliche Spannungsbereiche zu erfassen.

Um ASIL-C zu gewährleisten wird in diesem Ausführungsbeispiel das zweite Messmittel 207 benötigt, da die Spannungsversorgung des ersten Mittels für die Erfassung des ersten Spannungswerts und des dritten Spannungswert gleich ist, sodass eine unabhängige Referenz benötigt wird.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Vorrichtung (100, 200) zum Überprüfen einer Funktionsfähigkeit eines als Systemwiderstand dienenden ersten Widerstands (102, 202) eines Batteriesystems umfassend ein Mittel (105, 205) zum Bereitstellen eines modulierten Teststroms, einen Schalter (104, 204), einen zweiten Widerstand (103, 203), ein erstes Messmittel (106, 206) und ein zweites Messmittel (107, 207), wobei das erste Messmittel (106, 206) dazu eingerichtet ist, einen ersten Spannungswert einer über den ersten Widerstand (102, 202) abfallenden Wechselspannung zu erfassen, einen ersten Stromwert zu bestimmen und den ersten Stromwert mit Hilfe einer Verbindung (108, 208) an das zweite Messmittel (107, 207) zu übertragen, wobei das zweite Messmittel (107, 207) dazu eingerichtet ist einen zweiten Spannungswert einer über den zweiten Widerstand (103, 203) abfallenden Wechselspannung zu erfassen und einen zweiten Stromwert zu bestimmen, wobei das Mittel (105, 205) zum Bereitstellen eines modulierten Teststroms, der erste Widerstand (102, 202) und der zweite Widerstand (103, 203) in Reihe geschaltet sind und einen Teststromkreis bilden, und wobei das zweite Messmittel (107, 207) dazu eingerichtet ist, den ersten Stromwert und den zweiten Stromwert zu vergleichen und ein erstes Signal zu erzeugen, wenn der erste Stromwert und der zweite Stromwert im Wesentlichen gleich sind, wobei das erste Signal die Funktionsfähigkeit des ersten Widerstands (102, 202) repräsentiert.

2. Vorrichtung (200) nach Anspruch 1, **dadurch gekennzeichnet, dass** in dem Teststromkreis ein dritter Widerstand (209) vorgesehen ist, wobei das erste Messmittel (206) ferner dazu eingerichtet ist, einen dritten Spannungswert einer über den dritten Widerstand (209) abfallenden Wechselspannung zu erfassen, einen dritten Stromwert zu bestimmen und den dritten Stromwert mit Hilfe der Verbindung (208) an das zweite Messmittel (207) zu übertragen und das zweite Messmittel (207) das erste Signal erzeugt, wenn der erste Stromwert, der zweite Stromwert und der dritte Stromwert im Wesentlichen gleich sind.

3. Vorrichtung (100, 200) nach Anspruch 1 oder 2, **dadurch gekennzeichnet, dass** das erste Messmittel (106, 206) ein Analog-Front-End und das zweite Messmittel (107, 207) eine Steuereinheit eines Batteriemanagementsystems des Batteriesystems ist.

4. Vorrichtung (100, 200) nach einem der Ansprüche 1 bis 3, **dadurch gekennzeichnet, dass** das erste Messmittel (106, 206) einen Verstärker mit einem dynamischen Verstärkungsfaktor aufweist.

5. Vorrichtung (100, 200) nach Anspruch 4, **dadurch gekennzeichnet, dass** das erste Messmittel (206) dazu eingerichtet ist, unter Verwendung eines ersten Verstärkungsfaktors den ersten Stromwert zu bestimmen und unter Verwendung eines zweiten Verstärkungsfaktors den dritten Stromwert zu bestimmen und ein zweites Signal zu erzeugen, wenn der erste Stromwert und der dritte Stromwert im Wesentlichen gleich sind, wobei das zweite Signal die Funktionsfähigkeit des Verstärkers repräsentiert.

6. Vorrichtung (100, 200) nach einem der Ansprüche 1 bis 5, **dadurch gekennzeichnet, dass** das Mittel (105, 205) zum Bereitstellen eines modulierten Teststroms den Teststrom mit einer Messfrequenz moduliert und dass das erste Messmittel (106, 206) und das zweite Messmittel (107, 207) jeweils bei der Erfassung von Spannungswerten eine Frequenzfilterung vornehmen, welche Gleichspannung und Wechselspannungen mit von der Messfrequenz abweichenden Frequenzen unterdrückt.

7. Verfahren (300, 400) zum Überprüfen einer Funktionsfähigkeit eines ersten Widerstands (102, 202) eines Batteriesystems mit den Schritten:
• Schließen (310) eines Schalters (104, 204), um in einem Teststromkreis mit einem Mittel (105, 205) zum Bereitstellen eines modulierten Teststroms, einem ersten Widerstand (102, 202) und einem zweiten Widerstand (103, 203), welche in Reihe geschaltet sind, einen modulierten Teststrom bereitzustellen,
• Erfassen (330) eines ersten Spannungswerts einer über den ersten Widerstand (102, 202) abfallenden Wechselspannung mit Hilfe eines ersten Messmittels (106, 206),
• Bestimmen (340) eines ersten Stromwerts in Abhängigkeit des ersten Spannungswerts und eines Nennwerts des ersten Widerstands (102, 202),
• Erfassen (350) eines zweiten Spannungswerts einer über den zweiten Widerstand (103, 203) abfallenden Wechselspannung mit Hilfe des zweiten Messmittels (107, 207),
• Bestimmen (360) eines zweiten Stromwerts in Abhängigkeit des zweiten Spannungswerts und eines Nennwerts des zweiten Widerstands (103, 203),
• Übertragen (370) des ersten Stromwerts an das zweite Messmittel (107, 207),
• Erzeugen (380) eines ersten Signals, das die Funktionsfähigkeit des ersten Widerstands (102, 202) repräsentiert, wenn der erste Stromwert und der zweite Stromwert im Wesentlichen gleich sind.

8. Verfahren (400) nach Anspruch 7, **dadurch gekennzeichnet, dass** der Teststromkreis in der Reihenschaltung zusätzlich einen dritten Widerstand (209) umfasst und ein dritter Spannungswert mit Hilfe des ersten Messmittels (206) erfasst wird, ein dritter Stromwert in Abhängigkeit des dritten Spannungswerts und eines Nennwerts des dritten Widerstands (209) bestimmt wird, der dritte Stromwert an das zweite Messmittel (207) übertragen wird und das erste Signal erzeugt wird, wenn der erste Stromwert, der zweite Stromwert und der dritte Stromwert im Wesentlichen gleich sind.

9. Verfahren (300, 400) nach Anspruch 8, wobei das erste Messmittel (106, 206) einen Verstärker mit einem dynamischen Verstärkungsfaktor aufweist, **dadurch gekennzeichnet, dass** der erste Stromwert unter Verwendung eines ersten Verstärkungsfaktors bestimmt wird und der dritte Stromwert unter Verwendung eines zweiten Verstärkungsfaktors bestimmt wird und das Verfahren ferner das Erzeugen eines zweites Signals umfasst, wenn der erste Stromwert und der dritte Stromwert im Wesentlichen gleich sind, wobei das zweite Signal die Funktionsfähigkeit des Verstärkers repräsentiert.

10. Fahrzeug umfassend ein Batteriesystem mit einem ersten Widerstand (102, 202) als Systemwiderstand sowie eine Vorrichtung (100, 200) zur Überprüfung einer Funktionsfähigkeit des ersten Widerstands (102, 202) gemäß einem der Ansprüche 1 bis 6.

## Claims

1. Device (100, 200) for checking a functionality of a first resistance (102, 202) of a battery system, which first resistance acts as a system resistance, comprising means (105, 205) for providing a modulated test current, a switch (104, 204), a second resistance (103, 203), a first measuring means (106, 206) and a second measuring means (107, 207) wherein the first measuring means (106, 206) is configured to detect a first voltage value of an AC voltage, which is dropped across the first resistance (102, 202), to determine a first current value, and to transfer the first current value to the second measuring means (107, 207) by means of a connection (108, 208), wherein the second measuring means (107, 207) is configured to detect a second voltage value of an AC voltage, which is dropped across the second resistance (103, 203), and to determine a second current value, wherein the means (105, 205) for providing a modulated test current, the first resistance (102, 202) and the second resistance (103, 203) are connected in series and form a test circuit, and wherein the second measuring means (107, 207) is configured to compare the first current value and the second current value, and to generate a first signal if the first current value and the second current value are substantially equal, which first signal represents the functionality of the first resistance (102, 202) .

2. Device (200) according to Claim 1, **characterized in that** a third resistance (209) is provided in the test circuit, wherein the first measuring means (206) is additionally configured to detect a third voltage value of an AC voltage, which is dropped across the third resistance (209), to determine a third current value, and to transfer the third current value to the second measuring means (207) by means of the connection (208), and the second measuring means (207) generates the first signal if the first current value, the second current value and the third current value are substantially equal.

3. Device (100, 200) according to Claim 1 or 2, **characterized in that** the first measuring means (106, 206) is an analog front-end, and the second measuring means (107, 207) is a control unit of a battery management system of the battery system.

4. Device (100, 200) according to any of Claims 1 to 3, **characterized in that** the first measuring means (106, 206) comprises an amplifier having a dynamic gain factor.

5. Device (100, 200) according to Claim 4, **characterized in that** the first measuring means (206) is configured to determine the first current value using a first gain factor, and to determine the third current value using a second gain factor, and to generate a second signal if the first current value and the third current value are substantially equal, which second signal represents the functionality of the amplifier.

6. Device (100, 200) according to any of Claims 1 to 5, **characterized in that** the means (105, 205) for providing a modulated test current modulates the test current at a measurement frequency, and that the first measuring means (106, 206) and the second measuring means (107, 207) perform frequency filtering when each detect voltage values, which frequency filtering suppresses DC voltage and AC voltages at frequencies that differ from the measurement frequency.

7. Method (300, 400) for checking a functionality of a first resistance (102, 202) of a battery system, comprising the steps:
• closing (310) a switch (104, 204) in order to provide a modulated test current in a test circuit containing means (105, 205) for providing a modulated test current, a first resistance (102, 202) and a second resistance (103, 203), which are connected in series;
• detecting (330) by means of a first measuring means (106, 206) a first voltage value of an AC voltage, which is dropped across the first resistance (102, 202) ;
• determining (340) a first current value on the basis of the first voltage value and a nominal value of the first resistance (102, 202);
• detecting (350) by means of the second measuring means (107, 207) a second voltage value of an AC voltage, which is dropped across the second resistance (103, 203);
• determining (360) a second current value on the basis of the second voltage value and a nominal value of the second resistance (103, 203);
• transferring (370) the first current value to the second measuring means (107, 207);
• generating (380) a first signal, which represents the functionality of the first resistance (102, 202), if the first current value and the second current value are substantially equal.

8. Method (400) according to Claim 7, **characterized in that** the test circuit comprises in the series circuit additionally a third resistance (209), and a third voltage value is detected by means of the first measuring means (206), a third current value is determined on the basis of the third voltage value and a nominal value of the third resistance (209), the third current value is transferred to the second measuring means (207), and the first signal is generated if the first current value, the second current value and the third current value are substantially equal.

9. Method (300, 400) according to Claim 8, wherein the first measuring means (106, 206) comprises an amplifier that has a dynamic gain factor, **characterized in that** the first current value is determined using a first gain factor, and the third current value is determined using a second gain factor, and the method further comprises generating a second signal if the first current value and the third current value are substantially equal, which second signal represents the functionality of the amplifier.

10. Vehicle comprising a battery system having a first resistance (102, 202) as the system resistance and comprising a device (100, 200) according to any of Claims 1 to 6 for checking a functionality of the first resistance (102, 202).

## Revendications

1. Dispositif (100, 200) de vérification d'une capacité fonctionnelle d'une première résistance (102, 202) servant de résistance de système d'un système de batterie, comprenant un moyen (105, 205) destiné à fournir un courant de test modulé, un commutateur (104, 204), une deuxième résistance (103, 203), un premier moyen de mesure (106, 206) et un deuxième moyen de mesure (107, 207), dans lequel le premier moyen de mesure (106, 206) est conçu pour détecter une première valeur de tension d'une tension alternative chutant aux bornes de la première résistance (102, 202), pour déterminer une première valeur de courant et pour transmettre la première valeur de courant au deuxième moyen de mesure (107, 207) à l'aide d'une liaison (108, 208), dans lequel le deuxième moyen de mesure (107, 207) est conçu pour détecter une deuxième valeur de tension d'une tension alternative chutant aux bornes de la deuxième résistance (103, 203) et pour déterminer une deuxième valeur de courant, dans lequel le moyen (105, 205) destiné à fournir un courant de test modulé, la première résistance (102, 202) et la deuxième résistance (103, 203) sont connectés en série et forment un circuit de courant de test, et dans lequel le deuxième moyen de mesure (107, 207) est conçu pour comparer la première valeur de courant et la deuxième valeur de courant et pour générer un premier signal lorsque la première valeur de courant et la deuxième valeur de courant sont sensiblement égales, dans lequel le premier signal représente la capacité fonctionnelle de la première résistance (102, 202).

2. Dispositif (200) selon la revendication 1, **caractérisé en ce qu'**une troisième résistance (209) est prévue dans le circuit de courant de test, dans lequel le premier moyen de mesure (206) est en outre conçu pour détecter une troisième valeur de tension d'une tension alternative chutant aux bornes de la troisième résistance (209), pour déterminer une troisième valeur de courant et pour transmettre la troisième valeur de courant au deuxième moyen de mesure (207) à l'aide de la liaison (208), et le deuxième moyen de mesure (207) génère le premier signal lorsque la première valeur de courant, la deuxième valeur de courant et la troisième valeur de courant sont sensiblement égales.

3. Dispositif (100, 200) selon la revendication 1 ou 2, **caractérisé en ce que** le premier moyen de mesure (106, 206) est un frontal analogique et le deuxième moyen de mesure (107, 207) est une unité de commande d'un système de gestion de batterie du système de batterie.

4. Dispositif (100, 200) selon l'une des revendications 1 à 3, **caractérisé en ce que** le premier moyen de mesure (106, 206) comporte un amplificateur à facteur d'amplification dynamique.

5. Dispositif (100, 200) selon la revendication 4, **caractérisé en ce que** le premier moyen de mesure (206) est conçu pour déterminer la première valeur de courant en utilisant un premier facteur d'amplification et pour déterminer la troisième valeur de courant en utilisant un deuxième facteur d'amplification et pour générer un deuxième signal lorsque la première valeur de courant et la troisième valeur de courant sont sensiblement égales, dans lequel le deuxième signal représente la capacité fonctionnelle de l'amplificateur.

6. Dispositif (100, 200) selon l'une des revendications 1 à 5, **caractérisé en ce que** le moyen (105, 205) de fourniture d'un courant de test modulé module le courant de test avec une fréquence de mesure et **en ce que** le premier moyen de mesure (106, 206) et le deuxième moyen de mesure (107, 207) effectuent respectivement, lors de la détection de valeurs de tension, un filtrage de fréquence qui supprime la tension continue et les tensions alternatives ayant des fréquences qui s'écartent de la fréquence de mesure.

7. Procédé (300, 400) de vérification d'une capacité fonctionnelle d'une première résistance (102, 202) d'un système de batterie, comprenant les étapes consistant à :
• fermer (310) un commutateur (104, 204) destiné à fournir un courant de test modulé dans un circuit de courant de test comportant un moyen (105, 205) destiné à fournir un courant de test modulé, une première résistance (102, 202) et une deuxième résistance (103, 203) qui sont connectés en série,
• détecter (330) une première valeur de tension d'une tension alternative chutant aux bornes de la première résistance (102, 202) à l'aide d'un premier moyen de mesure (106, 206),
• déterminer (340) une première valeur de courant en fonction de la première valeur de tension et d'une valeur nominale de la première résistance (102, 202),
• détecter (350) une deuxième valeur de tension d'une tension alternative chutant aux bornes de la deuxième résistance (103, 203) à l'aide du deuxième moyen de mesure (107, 207),
• déterminer (360) une deuxième valeur de courant en fonction de la deuxième valeur de tension et d'une valeur nominale de la deuxième résistance (103, 203),
• transmettre (370) la première valeur de courant au deuxième moyen de mesure (107, 207),
• générer (380) un premier signal qui représente la capacité fonctionnelle de la première résistance (102, 202) lorsque la première valeur de courant et la deuxième valeur de courant sont sensiblement égales.

8. Procédé (400) selon la revendication 7, **caractérisé en ce que** le circuit de courant de test dans le montage en série comprend en outre une troisième résistance (209) et une troisième valeur de tension est détectée à l'aide du premier moyen de mesure (206), une troisième valeur de courant est déterminée en fonction de la troisième valeur de tension et d'une valeur nominale de la troisième résistance (209), la troisième valeur de courant est transmise au deuxième moyen de mesure (207) et le premier signal est généré lorsque la première valeur de courant, la deuxième valeur de courant et la troisième valeur de courant sont sensiblement égales.

9. Procédé (300, 400) selon la revendication 8, dans lequel le premier moyen de mesure (106, 206) comprend un amplificateur à facteur d'amplification dynamique, **caractérisé en ce que** la première valeur de courant est déterminée en utilisant un premier facteur d'amplification et la troisième valeur de courant est déterminée en utilisant un deuxième facteur d'amplification, et le procédé comprend en outre la génération d'un deuxième signal lorsque la première valeur de courant et la troisième valeur de courant sont sensiblement égales, dans lequel le deuxième signal représente la capacité fonctionnelle de l'amplificateur.

10. Véhicule comprenant un système de batterie présentant une première résistance (102, 202) en tant que résistance de système ainsi qu'un dispositif (100, 200) de vérification d'une capacité fonctionnelle de la première résistance (102, 202) selon l'une des revendications 1 à 6.
